# EUROPEAN PATENT SPECIFICATION

(11) **EP 2 325 258 B1**
(45) Date of publication and mention of the grant of the patent: **03.12.2014**
(21) Application number: 09806558.4
(22) Date of filing: 05.08.2009
(51) Int. Cl.: C08L 67/03, C08J 5/18, C08K 5/29, H01L 31/042, C08L 67/02, C08L 79/00

(54) **POLYBUTYLENE TEREPHTHALATE RESIN MIXTURE AND FILM**
POLYBUTYLEN-TEREPHTHALAT-HARZMISCHUNG UND -FOLIE
MÉLANGE À BASE DE RÉSINE TÉRÉPHTALATE DE POLYBUTYLÈNE ET FILM

(30) Priority: 12.08.2008 JP 2008207751
(43) Date of publication of application: 25.05.2011
(73) Proprietor: Wintech Polymer Ltd., Minato-ku Tokyo 108-8280 (JP)
(72) Inventor: NAKADA, Satomi, Fuji-shi Shizuoka 416-8533 (JP); SAITO, Tatsuya, Fuji-shi Shizuoka 416-8533 (JP); IKEDA, Daisaku, Tokyo 108-8280 (JP)
(74) Representative: Diehl & Partner GbR
(86) International application number: PCT/JP2009/003730
(87) International publication number: WO 2010/018662

(56) References cited:
- WO-A1-2009/123357
- WO-A1-2009/150830
- JP-A- 8 073 719
- JP-A- 9 124 908
- JP-A- 2003 251 695
- JP-A- 2004 122 289
- JP-A- 2007 129 204
- JP-A- 2007 129 204
- US-A1- 2003 170 475
- US-A1- 2005 143 503

## Description

### Technical Field

The present invention relates to a polybutylene terephthalate resin mixture which is suitably used for a film, specifically for a back sheet film for solar cell module.

### Background Art

Polybutylene terephthalte resins are used as engineering plastics in wide-ranging fields owing to their excellent mechanical properties, electric properties, and other physical and chemical properties, and their good processability.

In recent years, the polybutylene terephthalate resins are very often used in sheets and films. In particular, the application of polybutylene terephthalate resins proceeds in the technology development relating to photovoltaic power generation (solar cells). Solar cells are manufactured by, for example, a following procedure. The surface layer adopts a base material such as glass and film having light-permeability, on which the silicon- or other material-based solar cell modules are arranged attaching the lead wires to pull electricity therefrom, and the modules are fixed to the surface layer using a filler resin such as ethylene vinyl acetate resin, and a film to seal the back face (back sheet film) is positioned at rear side (rear face) of the filler resin, and finally the entire components are fixed by an exterior material. The film for sealing the back face (back sheet film) adopts a polyester-based resin film having high reflectance at the solar cell module side so as to reflect the solar light to enhance the electric conversion efficiency. The film for sealing the back face (back sheet film) is required to have durability such as weatherability and resistance to hydrolysis, and specifically required to have long period resistance to hydrolysis.

Compared with the fluorine-based resins and the polyethylene-based resins, the polyester-based resins are inferior in durability, and thus there have been provided many methods to improve the durability.

In processing the polyethylene terephthalate resins to form sheets and films, fine foreign materials generally called fisheyes may be generated, which may raise problems of deteriorating product appearance and damaging commercial product values.

To solve the above problems, for example, JP-A 8-73719 discloses the improvement of resistance to hydrolysis by adding carbodiimide to polybutylene terephthalate. The Patent disclosure, however, does not give the description of the uses in sheets and films, and does not give the description of fisheyes. Furthermore, the Patent disclosure substantially relates to a composition prepared by melt-kneading.

JP-A 2007-129204 discloses the improvement of resistance to hydrolysis by adding titanium to polybutylene terephthalate as the film for sealing back face of solar cell module. The effect is, however, not satisfactory.

JP-A 2001-270937 discloses a manufacturing method for decreasing fisheyes in a polybutylene terephthalate-based resin. The Patent disclosure is, however, a method for removing foreign materials mechanically.

### Disclosure of the Invention

The present invention has been made to solve the above problems in the related art, and an obj ect of the present invention is to provide

A film obtained by melt-extruding a polybutylene terephthalate resin mixture, the mixture obtainable by mixing
(A) polybutylene terephthalate resin, having an amount of carboxyl terminal groups of 5-20 meq/kg and an intrinsic viscosity of 0.9 dL/g or more as determined at 35°C in o-chlorophenol, with
(B) a carbodiimide compound in the form of powder, granule or a masterbatch having a polybutylene terephthalate resin as the matrix,
the film having less than five fisheyes of a size of 10 µm or larger per 1 cm² of film.

The present invention provides a film as the back sheet of solar cell module.

According to the present invention, there can be obtained a polybutylene terephthalate resin material for manufacturing film, having less fisheyes and having excellent resistance to hydrolysis. A polymer of polybutylene terephthalate resin mixture is especially useful as the back sheet film for solar cell module.

### Detail Description of the Invention

The structural components of the resin material of the present invention will be described in detail in the following. The (A) polybutylene terephthalate resin which is the basic resin of the resin composition of the present invention is a polybutylene terephthalate-based resin which is obtained by polycondensation of a dicarboxylic acid component containing at least terephthalic acid or an ester-forming derivative thereof (such as lower alcohol ester) and a glycol component containing at least a C4 alkylene glycol (1,4-butane diol) or an ester-forming derivative thereof. The polybutylene terephthalate resin is not limited to the homo-polybutylene terephthalate resin, and may be a copolymer containing 60% by mole or more, specifically 75 to 95% by mole, of butylene terephthalate unit.

The polybutylene terephthalate resin in the present invention is produced by dissolving a crushed polybutylene terephthalate sample in benzyl alcohol for 10 minutes at 215 ° C, followed by titrating the solution by using an aqueous solution of 0.01N sodium hydroxide to thereby be used as the polybutylene terephthalate resin having 20 meq/kg or less of the amount of terminal carboxyl group measured, preferably 15 meq/kg or less thereof.

The use of a polybutylene terephthalate resin having more than 20 meq/kg of the amount of terminal carboxyl group shortens the life of resistance to hydrolysis in a moist-heat environment even controlling the amount to be added of carbodiimide compound.

The lower limit of the amount of terminal carboxyl group is not specifically limited. However, the polybutylene terephthalate resin having less than 5 meq/kg of the amount of terminal carboxyl group is generally difficult to be produced, and the resin having less than 5 meq/kg thereof may not allow the reaction with carbodiimide compound to proceed sufficiently. Accordingly, the amount of terminal carboxyl group in the polybutylene terephthalate resin is preferably 5 meq/kg or more.

Furthermore, the intrinsic viscosity (IV) of the applied (A) polybutylene terephthalic resin is required to be 0.90 dL/g or more. If the intrinsic viscosity is less than 0.90 dL/g, the life of resistance to hydrolysis is not satisfactory as the back sheet film for solar cell module, in some cases. The intrinsic viscosity of 0.90 dL/g or more can also be attained by blending polybutylene terephthalate resins having different intrinsic viscosities from each other, for example, the one having an intrinsic viscosity of 1.1 dL/g and the one having an intrinsic viscosity of 0.70 dL/g. The intrinsic viscosity can be determined, for example, in o-chlorophenol at 35°C.

In the polybutylene terephthalate resin, examples of the dicarboxylic acid component (comonomer component) other than terephthalic acid and an ester-forming derivative thereof are: an aromatic dicarboxylic acid component (such as C₆-C₁₂ aryldicarboxylic acid including isophthalic acid, phthalic acid, naphthalene dicarboxylic acid, and diphenylether dicarboxylic acid); an aliphatic dicarboxylic acid component (such as C₄-C₁₆ alkyldicarboxylic acid including succinic acid, adipic acid, azelaicacid, andsebacicacid, and C₅-C₁₀ cycloalkyldicarboxylic acid including cyclohexane dicarboxylic acid); and an ester-forming derivative thereof. Those dicarboxylic acid components can be used alone or in combination of two or more thereof.

Preferable dicarboxylic acid component (comonomer component) includes an aromatic dicarboxylic acid component (specifically C₆-C₁₀ aryl dicarboxylic acid such as isophthalic acid) and an aliphatic dicarboxylic acid component (specifically C₆-C₁₂ alkyl dicarboxylic acid such as adipic acid, azelaic acid, or sebacic acid).

Examples of glycol component (comonomer component) other than 1, 4-butane diol are: an aliphatic diol component [such as alkylene glycol (including C₂-C₁₀ alkylene glycol such as ethylene glycol, propylene glycol, trimethylene glycol, 1,3-butylene glycol, hexamethylene glycol, neopenthyl glycol, or 1,3-octane diol, or polyoxy C₂-C₄ alkylene glycol such as diethylene glycol, triethylene glycol, or dipropylene glycol), or alicyclic diol such as cyclohexane dimethanol or hydrogenated bisphenol A]; an aromatic diol component [such as aromatic alcohol including bisphenol A and 4,4-dihydroxybiphenyl, or C₂-C₄ alkyleneoxide adduct of bisphenol A (for example, 2-mole adduct of ethylene oxide of bisphenol A and 3-mole adduct of propylene oxide of bisphenol A)]; and an ester-forming derivative thereof. These glycol components can also be used alone or in combination of two or more thereof.

Preferred glycol component (Comonomer component) includes an aliphatic diol component (specifically C₂-C₆ alkylene glycol, polyoxy C₂-C₃ alkylene glycol such as diethylene glycol, and alicyclic diol such as cyclohexane dimethanol).

Any of the polybutylene terephthalate-based polymers obtained by polycondensation of above compounds as the monomer components can be used as the (A) component of the present invention. The combined use of homo-polybutylene terephthalate polymer and polybutylene terephthalate copolymer is also useful.

The (B) carbodiimide compound used in the present invention is a compound having carbodiimide group (-N=C=N-) in the molecule. Applicable carbodiimide compound includes an aliphatic carbodiimide compound having the aliphatic main chain, an alicyclic carbodiimide compound having the alicyclic main chain, and an aromatic carbodiimide compound having the aromatic main chain, and a preferred one is an aromatic carbodiimide compound in terms of resistance to hydrolysis.

Examples of the aliphatic carbodiimide compound include diisopropyl carbodiimide, dioctyldecyl carbodiimide. An example of the alicyclic carbodiimide compound includes dicyclohexyl carbodiimide.

Examples of aromatic carbodiimide compound include: a mono- or di-carbodiimide compound such as diphenyl carbodiimide, di-2,6-dimethylphenyl carbodiimide, N-tolyl-N'-phenyl carbodiimide, di-p-nitrophenylcarbodiimide, di-p-aminophenyl carbodiimide, di-p-hydroxyphenyl carbodiimide, di-p-chlorophenyl carbodiimide, di-p-methoxyphenyl carbodiimide, di-3,4-dichlorophenyl carbodiimide, di-2,5-dichlorophenyl carbodiimide, di-o-chlorophenyl carbodiimide, p-phenylene-bis-di-o-tolyl carbodiimide, p-phenylene-bis-dicyclohexyl carbodiimide, p-phenylene-bis-di-p-chlorophenyl carbodiimide, or ethylene-bis-diphenyl carbodiimide; and a polycarbodiimide compound such as poly(4,4'-diphenylmethane carbodiimide), poly(3,5'-dimethyl-4,4'-biphenylmethane carbodiimide), poly(p-phenylene carbodiimide), poly(m-phenylene carbodiimide), poly(3,5'-dimethyl-4,4'-diphenylmethane carbodiimide), poly(naphthylene carbodiimide), poly(1,3-diisopropylphenylene carbodiimide), poly(1-methyl-3,5-diisopropylphenylene carbodiimide), poly(1,3,5-triethylphenylene carbodiimide), or poly(triisopropylphenylene carbodiimide). These compounds can be used in combination of two or more of them. Among these, specifically preferred ones to be used are di-2, 6-dimethylphenyl carbodiimide, poly(4,4'-diphenylmethane carbodiimide), poly(phenylene carbodiimide), and poly(triisopropylphenylene carbodiimide).

A preferred (B) carbodiimide compound to be used is the one having 7000 or larger molecular weight. The one having less than 7000 of molecular weight cannot provide sufficient resistance to hydrolysis, and may generate gas and odor when the retention time is long during molding.

The blending amount of (B) carbodiimide compound corresponds to the amount of carbodiimide functional group within the range of 0. 5 to 20 equivalents when the amount of the terminal carboxyl group in the (A) polybutylene terephthalate resin is set as 1.

If the amount of (B) component is excessively small, the effect of improving the resistance to heat shock, which is an object of the present invention, cannot be attained. If the amount thereof is excessively large, there likely appears the decrease in flowability and the generation of gel and carbide at the time of molding, and appear the sudden decrease in strength and the yellowing in a moist-heat environment. A preferred amount of the (B) component corresponds to the amount of carbodiimide functional group within the range of 1 to 5 equivalents.

According to the present invention, the (A) polybutylene terephthalate resin and the (B) carbodiimide compound are mixed together in any form of powder, granule, and masterbatch. When the composition pellets are formed by performing melt-kneading of (A) and (B) components, the number of heating cycles increases to enhance the possibility of thermal deterioration, which thus lowers the resistance to hydrolysis.

The form of powder referred to herein generally signifies the use of powder having a mean particle size within the range of 0.1 to 100 µm. The form of granule referred to herein generally signifies the use of granules having a mean granule size larger than the mean particle size of powder, or within the range of 100 µm to 10 mm.

A preferred mixing method is to blend the (B) carbodiimide compound as the masterbatch having a resin as the matrix. The use of masterbatch often allows easy handing in practical operations. A preferred masterbatch resin of the (B) carbodiimide compound is normally a polybutylene terephthalate resin matrix. However, a masterbatch prepared by other resin matrix is also applicable. For the case of masterbatch of polybutylene terephthalate resin matrix, the amount of the masterbatch may be adjusted so as to be within the range of specified addition amount of the (B) carbodiimide compound. Alternatively, components other than the carbodiimide compound are preliminarily formed to be homogeneous pellets in the step of melting and kneading, and the masterbatch pellets of the carbodiimide compound are dry-blended to thereby obtain the pellet-blend, which may be then used for molding.

The resin mixture according to the present invention can contain, as needed, other resins (such as thermoplastic resin) and varieties of additives within a range not deteriorating the effect of the present invention.

Examples of the other resins include polyester resin other than polybutylene terephthalate resin, (such as polyethylene terephthalate and polytrimethylene terephthalate), polyolefin-based resin, polystyrene-based resin, polyamide-based resin, polycarbonate, polyacetal, polyarylene oxide, polyarylene sulfide, fluorine resin, and copolymer such as acrylonitrile-styrene resin, acrylonitrile-butadiene-styrene resin, and ethylene-ethylacrylate resin. These other resins can be used separately or in combination of two or more of them.

Examples of the additives include inorganic filler (such as: fibrous filler including glass fiber, graphite fiber, silica fiber, alumina fiber, boron fiber, feldspar, potassium titanate whisker, and potassium borate whisker; sheet-shape filler including mica and glass flake; or powdery filler including silica, glass bead, glass bubble, kaolin, wollastonite, calcium silicate, talc, and calcium carbonate), organic filler (such as high melting aromatic polyester fiber, liquid crystalline polyester fiber, aromatic polyamide fiber, fluorine resin fiber, or polyimide fiber), stabilizer (such as antioxidant, UV absorbent, or thermal stabilizer), antistatic agent, flame retardant, assistant to flame retardant, thermoplastic elastomer, coloring agent (such as dye or pigment), lubricant, plasticizer, lubricant, mold-releasing agent, and crystal nucleating agent. These additives can be used alone or in combination of two or more of them.

The resin mixture used in the present invention can be readily prepared by facilities and method commonly used as the conventional resin composition preparation method. Nevertheless, the high resistance to hydrolysis can be maintained by conducting film-forming as a mixture, not by performing melt-kneading before the film-forming.

In the present invention, the film-forming method is not specifically limited, and there can be used various known methods such as inflation method and T-die method, without modification.

Normally the back sheet of a solar cell has the following main components: the outermost layer which is required to have weatherability and mechanical characteristics; the intermediate layer which is required mainly to have barrier to water vapor; and the innermost layer which is required to have heat resistance, moisture resistance, electric properties, and mechanical properties. Each of them is constituted by combining fluorine resin film, polyester film such as PET, PEN, or PBT, metal foil such as aluminum sheet, deposition film of alumina, silica. In order to provide each layer with light-blocking effect, reflectivity, and weatherability, there may be added an inorganic material such as titanium oxide, barium sulfate, or carbon black particles.

The polyester resin mixture of the present invention is preferably used together with these components. Applicable methods for forming the above layer structure include: co-extrusion method using two or more melt-extruders for obtaining laminated films having two or more layers; extrusion laminating method for forming stretched or non-stretched films; and dry laminating method.

The present invention can provide a film having very few fisheyes, or having less than five thereof of 10 µm or larger size per 1 cm² of film.

Since there can be obtained a film having very high resistance to hydrolysis, when the film is used as a back sheet film for solar cell module, the module has high durability and light weight, thus being able to contribute to efficient use of energy, which provides very high industrial value.

### Examples

The present invention will be described in more detail in the following. However, the present invention is not limited to these examples.

### Examples 1 to 9, Comparative Examples 1 to 6

The respective components listed in Table 1 were weighed and then dry-blended, followed by compounding by the method indicated in Table 1, and then the respective films having a thickness of 50 µm were produced by the T-die method. From the respective films, the respective test pieces were cut to measure physical properties. The result is also indicated in Table 1.

In the compounding method of Table 1, the symbol "MB" signifies the compound mixed by the masterbatch, the symbol "powder" signifies the compound of powder mixing or granule mixing, and the symbol "melt" signifies the compound produced by performing melt-kneading of the components in a 30 mm dia. twin screw extruder (TEX-30, manufactured by The Japan Steel Works, Ltd.) under cylinder temperature of 260 °C, extrusion rate of 15 kg/h, and screw rotational speed of 150 rpm.

The detail of the components used and the measurement method for evaluating the physical properties are given below.

### (A) Polybutylene terephthalate resin

- (A-1) Manufactured by WinTech Polymer Ltd.; intrinsic viscosity of 1.1 dL/g, and amount of terminal carboxyl group of 8 meq/kg
- (A-2) Manufactured by WinTech Polymer Ltd.; intrinsic viscosity of 0.88 dL/g, and amount of terminal carboxyl group of 15 meq/kg
- (A-3)

To a reaction vessel equipped with an agitator and a distillation column, there were supplied 88 parts by weight of dimethyl terephthalate, 61 parts by weight of 1,4-butanediol, and 0. 07 parts by weight of tetrabutyl titanate, which were then heated while agitating thereof under nitrogen atmosphere. After 30 min, the mixture reached 145 °C, and methanol distillate generated by the ester exchange reaction was observed. Further, the temperature of the mixture was increased up to 210 ° C in 100 min. Atthatmoment, the methanol distilled by the ester exchange reaction reached 26.5 parts by weight, which was 91% relative to the theoretical value. Then, the reaction system pressure was carefully and gradually decreased while raising the temperature of the reaction system to reach 250 ° C and 0.5 Torr (or 66.5 Pa) in 30 min. By maintaining the system so as to be 250°C and 0.5 Torr, the polycondensation reaction was caused to proceed for 140 min. Then, nitrogen gas was introduced to the reaction system to return the system pressure to ordinary pressure. After being allowed to stand in that state for 15 min, the bottom valve of the reaction vessel was opened to discharge the polymer in strand shape, which was then cooled to be solidified in water, and then was cut by using a strand cutter for 20 min to carry out pelletization. The intrinsic viscosity and the amount of carboxyl terminal group of the pellets were measured to be 1.1 dL/g and 45 meq/kg, respectively.
- (A-4)

To a reaction vessel equipped with an agitator and a distillation column, there were supplied 88 parts by weight of dimethyl terephthalate, 61 pars by weight of 1,4-butanediol, 0.07 parts by weight of tetrabutyl titanate, and 0.005 parts by weight of sodium acetate, which were then heated while agitating thereof under nitrogen atmosphere. After 30 min, the mixture reached 145 °C, and methanol distillate by the ester exchange reaction was observed. Further, the temperature of the mixture was increased up to 210 ° C in 100 min. At that moment, the methanol distilled by the ester exchange reaction reached 25.9 parts by weight, which was 89% relative to the theoretical value. Then, the reaction system pressure was carefully and gradually decreased while raising the temperature of the reaction system to reach 250°C and 0.5 Torr (or 66.5 Pa) in 30 min. By maintaining the system so as to be 250°C and 0.5 Torr, the polycondensation reaction was caused to proceed for 90 min. Then nitrogen gas was introduced to the reaction system to return the system pressure to ordinary pressure. After a being allowed to stand in that state for 15 min, the bottom valve of the reaction vessel was opened to discharge the polymer in strand shape, which was then cooled to be solidified in water, and then was cut by using a strand cutter for 20 min to carry out pelletization.

The entire amount of the prepolymer thus obtained was supplied to a reaction vessel equipped with a nitrogen-feed pipe and a vent pipe and being controllable to a specified temperature. Nitrogen was supplied to the reaction vessel at a volume rate of twice the polymer volume per minute. The temperature of the reaction vessel and the temperature of the nitrogen supplied were set to 190 °C. In that state, the solid phase polymerization was conducted for 8 hours. The intrinsic viscosity and the amount of carboxyl terminal group in the pellets were measured to be 0.85 dL/g and 8 meq/kg, respectively.
- (A-5)

To a reaction vessel equipped with an agitator and a distillation column, there were charged 88 parts by weight of dimethyl terephthalate, 61 pars by weight of 1,4-butanediol, 0.07 parts by weight of tetrabutyl titanate, and 0.003 parts by weight of sodium acetate, which were then heated while agitating thereof under nitrogen atmosphere. After 30 min, the mixture reached 145 °C, and methanol distillate generated by the ester exchange reaction was observed. Further, the temperature of the mixture was increased up to 210°C in 100 min. At that moment, the methanol distilled by the ester exchange reaction reached 26.2 parts by weight, which was 90% relative to the theoretical value. Then, the reaction system pressure was carefully and gradually decreased while raising the temperature of the reaction system to reach 250°C and 0.5 Torr (or 66.5 Pa) in 30 min. By maintaining the system so as to be 250°C and 0.5 Torr, the polycondensation reaction was caused to proceed for 100 min. Then nitrogen gas was introduced to the reaction system to return the system pressure to ordinary pressure. After allowing to standing the system in that state for 15 min, the bottom valve of the reaction vessel was opened to discharge the polymer in strand shape, which was then cooled to be solidified in water, and then was cut by using a strand cutter for 20 min to carry out pelletization.

The entire amount of the prepolymer thus obtained was supplied to a reaction vessel equipped with a nitrogen-feed pipe and a vent pipe and being controllable to a specified temperature. Nitrogen was supplied to the reaction vessel at a volume rate of twice the polymer volume per minute. The temperature of the reaction vessel and the temperature of the nitrogen supplied were set to 190°C. In that condition, the solid phase polymerization was conducted for 14 hours. The intrinsic viscosity and the amount of carboxyl terminal group in the pellets were found to be 1.1 dL/g and 15 meq/kg, respectively.

### (B) Carbodiimide compound

- (B-1) Aromatic carbodiimide compound: Stabaxol P100 (283 µm of median diameter), manufactured by Rhein Chemie Japan Ltd.
- (B-2) Aromatic carbodiimide compound: Stabaxol P (73 µm of median diameter), manufactured by Rhein Chemie Japan Ltd.
- (B-3) Polybutylene terephthalate masterbatch of aromatic carbodiimide compound: Stabaxol KE9193, manufactured by Rhein Chemie Japan Ltd.
- (B-4) Dry-blending the (A-1) polybutylene terephthalate resin with the (B-2) carbodiimide compound so that the content of the carbodiimide compound is 15% by weight through weighing, which were then melt-kneaded in a 30 mm dia. twin screw extruder (TEX-30, manufactured by The Japan Steel Works, Ltd.) under cylinder temperature of 260 °C, extrusion rate of 15 kg/h, and screw rotational speed of150 rpm to produce pellets.
- (B-5) Aliphatic carbodiimide compound: Carbodilite LA-1 (666 µm of median diameter), manufactured by Nisshinbo Chemical Inc.

The particle size of the carbodiimide compound was measured by using a particle size distribution tester, manufactured by HORIBA Inc. and water as the dispersant under a condition of ultrasound for 2 min.

### [Film-forming condition]

The film was formed to be a thickness of 50 µm by using a 20 mm dia. plastomill, manufactured by Toyo Seiki Seisaku-sho, Ltd. , equipped with a T-die (150 mm of lip width) under cylinder temperature of 250°C, 50 rpm, and roll temperature of 30°C. The material was dried at 140°C for 3 hours.

### [PCT test]

For the film produced by the plastomill, the PCT test (121 °C, 2 atm) was carried out. After the test, the tensile strength holding rate was evaluated as the resistance to hydrolysis.

### [Fisheye evaluation]

For the film produced by the plastomill, the number of fisheyes having a size of 10 µm or larger per 1 cm² of film was counted by using a light microscope.

**[Table 1]**

| | | Examples | | | | | | | | | Comparative Examples | | | | | |
|---|---|---|---|---|---|---|---|---|---|---|---|---|---|---|---|---|
| | | 1 | 2 | 3 | 4 | 5 | 6 | 7 | 8 | 9 | 1 | 2 | 3 | 4 | 5 | 6 |
| (A) | A-1 (parts by weight) | 96.7 | 99.5 | 93.4 | 96.7 | 99.5 | 91.1 | | 99.5 | 73.6 | | | | 99.5 | | 100 |
| | A-2 (parts by weight) | | | | | | | | | | 96:7 | | | | 99.5 | |
| | A-3 (parts by weight) | | | | | | | | | | | 96.7 | | | | |
| | A-4 (parts by weight) | | | | | | | | | | | | 96.7 | | | |
| | A-5 (parts by weight) | | | | | | | 96.7 | | | | | | | | |
| (B) | B-1 (parts by weight) | | 0.5 | | | | | | | | | | | 0.5 | | |
| | B-2 (parts by weight) | | | | | 0.5 | | | | | | | | | | |
| | B-3 (parts by weight) | 3.3 | | 6.6 | | | 9.9 | 3.3 | | 26.4 | 3.3 | 3.3 | 3.3 | | | |
| | B-4 (parts by weight) | | | | 3.3 | | | | | | | | | | | |
| | B-5 (parts by weight) | | | | | | | | 0.5 | 0.5 | | | | | 0.5 | |
| Carbodiimide equivalent / Amount of carboxyl group | | 2.14 | 2.14 | 4.29 | 1.97 | 1.97 | 6.47 | 1.14 | 2.7 | 17.8 | 1.14 | 0.38 | 2.14 | 2.14 | 1.44 | - |
| Compounding method | | MB | Powder | MB | MB | Powder | MB | MB | Powder | MB | MB | MB | MB | Melt | Powder | - |
| Evaluation | Holding time at 50% tensile (hr) | 140 | 140 | >200 | 126 | 126 | >200 | 112 | 67 | >200 | 73 | 52 | 86 | 100 | 36 | 100 |
| | Fisheyes (counts/1 cm²) | 2 | 2 | 1 | 2 | 2 | 1 | 2 | 2 | 1 | 2 | 2 | 2 | 2 | 2 | 15 |

As shown in Table 1, the films obtained in Examples by mixing a polybutylene terephthalate resin having 20 meq/kg or less of the amount of carboxyl terminal group and having 0.9 dL/g or larger intrinsic viscosity, and a specified amount of carbodiimide compound in a form of powder mixture, granule mixture, or masterbatch exhibited high resistance to hydrolysis and generated less fisheyes.

## Claims

1. A film obtained by melt-extruding a polybutylene terephthalate resin mixture, the mixture obtainable by mixing
(A) polybutylene terephthalate resin, having an amount of carboxyl terminal groups of 5-20 meq/kg and an intrinsic viscosity of 0.9 dL/g or more as determined at 35°C in o-chlorophenol, with
(B) a carbodiimide compound in the form of powder, granule or a masterbatch having a polybutylene terephthalate resin as the matrix,
the film having less than five fisheyes of a size of 10 µm or larger per 1 cm² of film.

2. The film according to claim 1, wherein the molecular weight of the (B) carbodiimide compound is 7000 or more.

3. The film according to claim 1 or claim 2, wherein the mixing rate of the (B) carbodiimide compound is specified so that the amount of the carbodiimide functional groups of the (B) carbodiimide compound is 0.5 to 20 equivalents when the amount of carboxyl terminal groups in the (A) polybutylene terephthalate resin is set as 1.

4. The film according to one of claims 1 to 3, further comprising one or two or more of: a stabilizer, such as an antioxidant, UV absorbent, or thermal stabilizer; an antistatic agent; a flame retardant or assistant thereto; a coloring agent, such as a dye or pigment; a lubricant; a plasticizer; a glidant; a mold-releasing agent; or a crystal nucleating agent.

5. A back sheet film for a solar cell module, being the film according to one of claims 1 to 4.

## Patentansprüche

1. Folie, die durch Schmelzextrudieren einer Polybutylenterephthalat-Harzmischung erhalten wird, wobei die Mischung durch Mischen erhältlich ist von
(A) Polybutylenterephthalatharz, das eine Menge an endständigen Carboxylgruppen von 5 - 20 mäq/kg und eine intrinsische Viskosität von 0,9 dl/g oder mehr, wie bei 35 °C in o-Chlorphenol bestimmt, aufweist, mit
(b) einer Carbodiimidverbindung in Form von Pulver, Granulat oder einem Masterbatch, das ein Polybutylenterephthalatharz als Matrix aufweist,
wobei die Folie weniger als fünf Fisheyes einer Größe von 10 µm oder mehr pro 1 cm² Folie aufweist.

2. Folie nach Anspruch 1, wobei das Molekulargewicht der Carbodiimidverbindung (B) 7000 oder mehr beträgt.

3. Folie nach Anspruch 1 oder Anspruch 2, wobei der Mischungsanteil der Carbodiimidverbindung (B) so festgelegt ist, dass die Menge der funktionellen Carbodiimidgruppen der Carbodiimidverbindung (B) 0,5 bis 20 Äquivalente beträgt, wenn die Menge der endständigen Carboxylgruppen im Polybutylenterephthalatharz (A) als 1 gesetzt ist.

4. Folie nach einem der Ansprüche 1 bis 3, des Weiteren umfassend eines oder zwei oder mehr von: einem Stabilisator, wie beispielsweise einem Oxidationsmittel, UV-Absorptionsmittel oder Wärmestabilisator; einem Antistatikmittel; einem Flammschutzmittel oder Hilfsmittel dafür; einem Farbmittel wie beispielsweise einem Farbstoff oder Pigment; einem Gleitmittel; einem Weichmacher; einem Fließreguliermittel; einem Entformungsmittel; oder einem Kristallkeimbildner.

5. Rückseitenfolie für ein Solarzellenmodul, wobei die Folie einem der Ansprüche 1 bis 4 entspricht.

## Revendications

1. Film obtenu par extraction à l'état fondu d'un mélange de résine de téréphtalate de polybutylène,
le mélange pouvant être obtenu par mélange de
(A) une résine de téréphtalate de polybutylène, ayant une quantité de groupements terminaux carboxyle de 5-20 meq/kg et une viscosité intrinsèque de 0,9 dL/g ou plus comme déterminé à 35°C dans du o-chlorophénol, avec
(B) un composé carbodiimide sous la forme de poudre, de granule ou d'un mélange maître ayant une résine de téréphtalate de polybutylène en tant que matrice,
le film ayant moins de cinq fisheyes de taille de 10 µm ou plus large par 1 cm² de film.

2. Film selon la revendication 1, dans lequel le poids moléculaire du composé carbodiimide (B) est de 7000 ou plus.

3. Film selon la revendication 1 ou la revendication 2, dans lequel le taux de mélange du composé carbodiimide (B) est défini de sorte que la quantité des groupements fonctionnels carbodiimide du composé carbodiimide (B) est de 0,5 à 20 équivalents lorsque la quantité de groupements terminaux carboxyle dans la résine téréphtalate de polybutylène (A) est fixée à 1.

4. Film selon l'une des revendications 1 à 3, comprenant en outre un ou deux ou plus de : un stabilisateur, tel qu'un antioxydant, absorbant d'UV, ou stabilisateur thermique ; un agent antistatique ; un retardateur de flamme ou un assistant de celui-ci ; un agent de coloration, tel qu'un colorant ou pigment ; un lubrifiant ; un plastifiant ; un agent de glissement ; un agent de démoulage ; ou un agent de nucléation de cristaux.

5. Film de couche arrière pour un module de cellule solaire, étant le film selon l'une des revendications 1 à 4.
